Europäisches Patentamt

European Patent Office

Office européen des brevets

(19)

(11) **EP 1 227 594 A1**

(12) **EUROPÄISCHE PATENTANMELDUNG**

(43) Veröffentlichungstag:
**31.07.2002 Patentblatt 2002/31**

(51) Int Cl.$^7$: **H03M 3/02**

(21) Anmeldenummer: **01101969.2**

(22) Anmeldetag: **29.01.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **SIEMENS AKTIENGESELLSCHAFT**
**80333 München (DE)**

(72) Erfinder: **Jelonnek, Bjoern, Dr.**
**89079 Ulm (DE)**

(54) **Sigma-Delta-Modulator zur Digitalisierung von analogen Hochfrequenzsignalen**

(57)    Es wird ein Sigma-Delta-Modulator zur Digitalisierung eines Hochfrequenz-Eingangssignals mit einem analogen Eingang, einem digitalen Ausgang und einem Rückkoppelzweig zur Unterdrückung von Quantisierungsfehlern beschrieben, welcher dadurch gekennzeichnet ist, daß er Mittel zur Umwandlung des digitalen Ausgangssignals in ein analoges Signal und Mittel zur Subtraktion des umgewandelten Signals von dem analogen Eingangssignal aufweist, wobei das derart erzielte analoge Summensignal an einem analogen Ausgang anliegt.

– Figur 4 –

EP 1 227 594 A1

**Beschreibung**

Sigma-Delta-Modulator zur Digitalisierung von analogen Hochfrequenzsignalen

Die vorliegende Erfindung betrifft einen Sigma-Delta-Modulator nach dem Oberbegriff des Patentanspruchs 1, sowie ein System und ein Verfahren zur Digitalisierung von analogen Hochfrequenzsignalen mit Hilfe von Sigma-Delta-Modulatoren.

Zur Digitalisierung von Hochfrequenzsignalen existieren im wesentlichen zwei verschiedene Verfahren. Nach dem sogenannten Heterodyn- oder Superheterodyn-Verfahren wird das Hochfrequenzsignal über eine oder mehrere Stufen auf eine tieffrequente Zwischenfrequenz bzw. in das komplexe Basisband (Direct Conversion) umgesetzt. Das hierbei entstehende Signal wird anschliessend durch einen oder - im Falle einer Frequenzumsetzung in das komplexe Basisband - durch zwei konventionelle Analog-Digitalwandler (A/D-Wandler) sowie zusätzliche Mischer in den digitalen Bereich überführt.

Jedoch beeinträchtigen die in diesem Verfahren verwendeten Mischer und Filter durch ihre Nichtlinearitäten die Qualität des analog-digital gewandelten Signals und stellen zum anderen einen erheblichen Kostenfaktor dar. Ferner werden im Fall einer Frequenzumsetzung in das komplexe Basisband Inphase- und Quadraturkomponente realisierungsbedingt mit einem unterschiedlichen Skalierungsfaktor versehen (I/Q-Mismatch), was zu Spiegelfrequenzsignalen im Ausgangsspektrum des A/D-Wandlers führt.

Alternativ lässt sich das analoge Hochfrequenzsignal direkt in ein Digitalsignal umwandeln, beispielsweise mit Hilfe eines Bandpass-Sigma-Delta-A/D-Wandlers. Konzeptionsbedingt tritt bei diesem Verfahren kein I/Q-Mismatch auf. Aufgrund der notwendigen hohen Abtastraten bei HF-Signalen verwenden Bandpass-Sigma-Delta-A/D-Wandler bei ihrem Schwellwertentscheider (Komparator) jedoch nur wenige Signalzustände. Um die Leistung des Quantisierungsfehlers in dem gewünschten Bandpassbereich dennoch gering zu halten, wird das Quantisierungsfehlersignal über einen Digital-Analog-Wandler (D/A-Wandler) sowie ein Bandpassfilter rückgekoppelt und dem Komparator wieder zugeführt. Bei Verwendung von nur zwei Signalzuständen (1 Bit Ausgangssignal) ist theoretisch die Realisierung von A/D-Wandlern sehr hoher Linearität möglich. Eine Darstellung bestehender Sigma-Delta-Modulatoren wird in "Delta-Sigma Data Converters, Theory, Design and Simulation" von S.R. Norsworthy, R. Schreier und G. Temes, IEEE Press 1997, ISBN 0-7803-1045-4, gegeben.

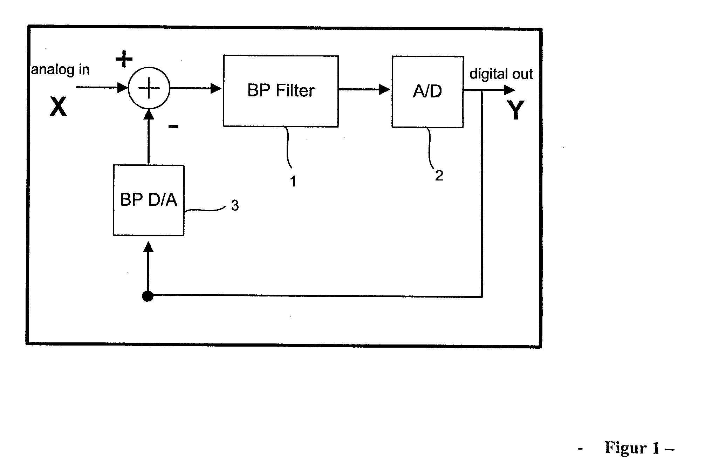

Aufgrund der angestrebten Rauschformung des Quantisierungsfehlers wird bei den Bandpass-Sigma-Delta-Modulatoren häufig eine Filterstruktur zweiter Ordnung verwendet, wie sie in Figur 1 dargestellt ist. Filterstrukturen dritter und höherer Ordnung führen insbesondere wegen der zusätzlich in der Rückkopplungsschleife auftretenden Verzögerungszeiten aufgrund des Komparators und des Bandpass-D/A-Wandlers zu Stabilitätsproblemen des Bandpass-Sigma-Delta-Modulators.

Ferner wird die Stabilität der Bandpass-Sigma-Delta-Modulatoren durch relativ hohe Laufzeitdifferenzen beeinträchtigt, welche in den Bandpassfiltern aufgrund der HF-Signalfrequenzen von mehreren GHz auftreten. Auch lassen sich wegen der erforderlichen hohen Induktivitäten in einer hochintegrierten Schaltung keine Bandpass-Filter hoher Güte realisieren. Die niedrige Güte der Filter führt zu einem unbefriedigendem Signal-Rauschverhältnis des Bandpass-Sigma-Delta-Modulators im Nutzsignalbereich.

Aktive Schaltungen, wie sie beispielsweise in "A Linear Integrated LC-Bandpass Filter with Q-Enhancement", Weinan Gao, W. Martin Snelgrove, IEEE Transactions on Circuits and Systems II: Analog and Digital Processing, Vol. 45, No. 5, May 1998 beschrieben werden, können die Güte des analogen Filters zwar erhöhen, generieren jedoch zusätzliche Nichtlinearitäten, welche sich auf das Signal-Rauschverhältnis des gesamten Bandpass-Sigma-Delta-Modulators auswirken.

Der Einfluss der Filtergüte auf das Signal-Rauschverhältnis des Modulators kann teilweise kompensiert werden, indem zwei oder mehr Bandpass-Sigma-Delta-Modulatoren kaskadiert werden. Hierbei wird das Fehlersignal am Eingang des Komparators der ersten Stufe der Kaskade als Eingangssignal für die zweite Stufe verwendet. Auf diese Weise werden Quantisierungsfehlersignalanteile innerhalb des Nutzbandes noch einmal digitalisiert und der digitalen Auswerteeinheit der zweiten Stufe zugeführt. Jedoch lassen sich derart die Nichtlinearitäten der Bandpass-Filter nicht verbessern.

Aufgabe der Erfindung ist es daher, einen stabilen Sigma-Delta-Modulator mit einem hohen Signal-Rauschverhältnis zu schaffen.

Diese Aufgabe wird gelöst durch einen Sigma-Delta-Modulator zur Digitalisierung eines Hochfrequenz-Eingangssignals mit einem analogen Eingang, einem digitalen Ausgang und einem Rückkoppelzweig zur Unterdrückung von Quantisierungsfehlern, welcher dadurch gekennzeichnet ist, daß er Mittel zur Umwandlung des digitalen Ausgangssignals in ein analoges Signal und Mittel zur Subtraktion des derart umgewandelten Signals von dem analogen Eingangssignal aufweist, wobei das derart erzielte Summensignal an einem analogen Ausgang anliegt. Eine durch die Aufbereitung verursachte zusätzliche Verzögerung des Signals kann nicht zu Stabilitätsproblemen führen, da die Aufbereitung nicht im Rückkoppelzweig des Sigma-Delta-Modulators erfolgt. Da das Signal-Rausch-Verhältnis bei einem erfindungsgemäßen Sigma-Delta-Modulator allein durch das Signal-Rausch-Verhältnis des durch die Mittel zur Umwandlung des digitalen Ausgangssignals in ein analoges Signal, die Mittel zur Aufbereitung des Signals und die Mittel zur Subtraktion des derart umgewandelten Signals von dem analogen Eingangssignals gebildeten direkten Pfades bestimmt wird, können in dem rückgekoppelten übrigen Teil des Sigma-Delta-Modulators Nichtlinearitäten sowie Filter geringer Güte toleriert werden. Insbesondere dieser Teil des Sigma-Delta-Modulators läßt sich daher vorteilhaft als integrierte Schaltung realisieren.

Die Aufgabe wird ferner gelöst durch ein System zur Umwandlung eines analogen Eingangssignals in ein digitales Ausgangssignal mit n Sigma-Delta-Modulatoren (n = 1, 2, 3, ...), welches dadurch gekennzeichnet ist, daß die Sigma-Delta-Modulatoren derart kaskadiert sind, daß das jeweilige analoge Ausgangssignal eines Sigma-Delta-Modulators das Eingangssignal eines folgenden Sigma-Delta-Modulators bildet.

Desweiteren wird die Aufgabe gelöst durch ein Verfahren zur Digitalisierung von analogen Hochfrequenzsignalen mit Hilfe von n Sigma-Delta-Modulatoren, mit folgenden Schritten, welche n-fach (n = 1, 2, ...) von a) bis e) wiederholt werden:

> a) Filterung des analogen Eingangssignals,
> b) Quantisierung des analogen Eingangssignals mit einer Abtastrate $f_a$, zu Zeitpunkten t = m * $T_a$, wobei m = 0, 1, 2,... und $T_a$ die Abtastperiode eines Sigma-Delta-Modulators ist, und Ausgabe des quantisierten Signals,
> c) Umwandlung des quantisierten Signals in ein analoges Signal,
> d) Subtraktion des umgewandelten analogen Signals von dem analogen Eingangssignal des Sigma-Delta-Modulators derselben Verfahrensstufe,
> e) Verwendung des summierten Signals als analoges Eingangssignal des Sigma-Delta-Modulators der folgenden Verfahrensstufe,

> und

> -   Auswertung der n quantisierten Signale der n Verfahrensstufen.

Gemäß einer vorteilhaften Ausgestaltung des Sigma-Delta-Modulators weist dieser Mittel auf, durch die Amplitude, Frequenz und/oder Phasenlage des analogen Eingangssignals veränderbar sind, so daß Anpassungen des analogen Eingangssignals an das von diesem subtrahierte umgewandelte analoge Signal möglich sind.

Vorteilhaft weist der Sigma-Delta-Modulator Bandpässe zur Frequenzumsetzung des Hochfrequenz-Eingangssignals auf.

Gemäß einer weiteren Ausgestaltung weist der Sigma-Delta-Modulator Mischer zur Aufspaltung des Eingangssignals in eine Inphase- und eine Quadraturkomponente sowie Tiefpässe zur Umsetzung der Inphase- und der Quadraturkomponente des Hochfrequenz-Eingangssignals in niederfrequentere Signale auf.

Bevorzugt weist das System eine Einheit zur Auswertung der n digitalen Ausgangssignale der n Sigma-Delta-Modulatoren auf.

Vorteilhafte Ausgestaltungen des erfindungsgemässen Sigma-Delta-Modulators, des Systems mit n Sigma-Delta-Modulatoren und des Verfahren sind Gegenstand weiterer Unteransprüche.

Die Erfindung wird nun anhand der beigefügten Zeichnung im Einzelnen beschrieben. Hierbei zeigen

Figur 1    ein Blockschaltbild eines Bandpass-Sigma-Delta-Modulators erster Ordnung gemäß dem Stand der Technik,

Figur 2    ein Blockschaltbild eines Tiefpass-Sigma-Delta-Modulators zweiter Ordnung gemäß dem Stand der Technik,

Figur 3    ein Blockschaltbild eines zweistufig kaskadierten Bandpass-Sigma-Delta-Modulators zweiter Ordnung gemäß dem Stand der Technik,

Figur 4    ein Blockschaltbild eines erfindungsgemässen Sigma-Delta-Modulators,

Figur 5    ein Blockschaltbild einer weiteren Ausführungsform eines erfindungsgemäßen Sigma-Delta-Modulators, und

Figur 6    ein Blockschaltbild der Gesamtstruktur eines erfindungsgemässen Systems mit drei Sigma-Delta-Modulatoren.

In Figur 1 ist die Grundstruktur eines Bandpass-Sigma-Delta-Modulators erster Ordnung dargestellt. Das analoge Eingangssignal X wird über ein Bandpass-Filter 1 zu einem Analog-Digital-Wandler 2 geführt. Das digitale Ausgangssignal des Analog-Digital-Wandlers 2 wird anschließend über eine Rückkopplungsschleife, welche einen Bandpass-Digital-Analog-Wandler 3 aufweist, zum Eingang zurückgeführt und von dem Eingangssignal X subtrahiert.

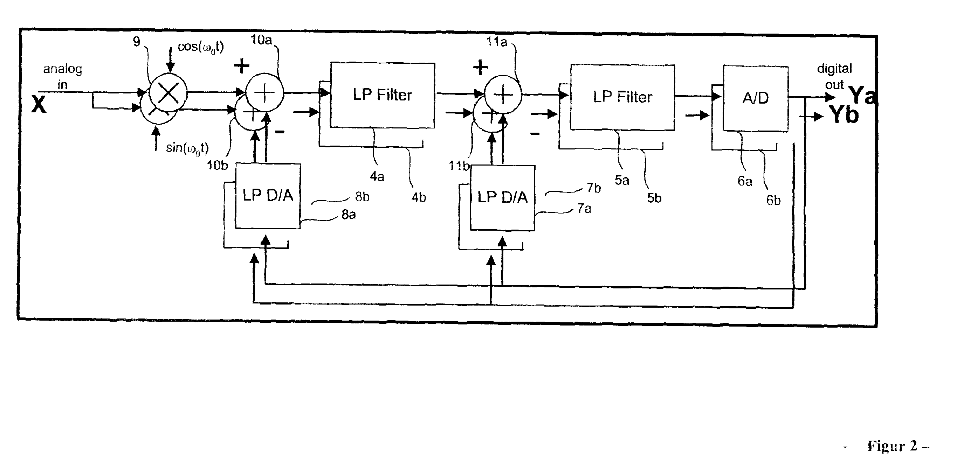

Ein Tiefpass-Sigma-Delta-Modulator zweiter Ordnung, wie aus dem Stand der Technik bekannt, wird in Figur 2 dargestellt. Das analoge Eingangssignal X wird in einem Mischer 9 mittels Multiplikation mit einem cos- bzw. einem sin-Signal in eine Inphase- und eine Quadratur-Komponente aufgespalten (Direct Conversion). Jede Komponente wird jeweils über zwei Tiefpässe 4a bzw. 4b und 5a bzw. 5b gefiltert und anschließend in einem Analog-Digital-Wandler 6a bzw. 6b abgetastet. Das digitale Ausgangssignal Ya bzw. Yb wird in zwei Rückkopplungsschleifen über Tiefpass-Digital-Analog-Wandler 7a bzw. 7b und 8a bzw. 8b den Summierern 10a bzw. 10b zugeführt und jeweils von dem analogen Signal subtrahiert. Die Zusammenführung der beiden digitalen Ausgangssignale Ya und Yb erfolgt in einer (nicht dargestellten) Auswerteeinheit.

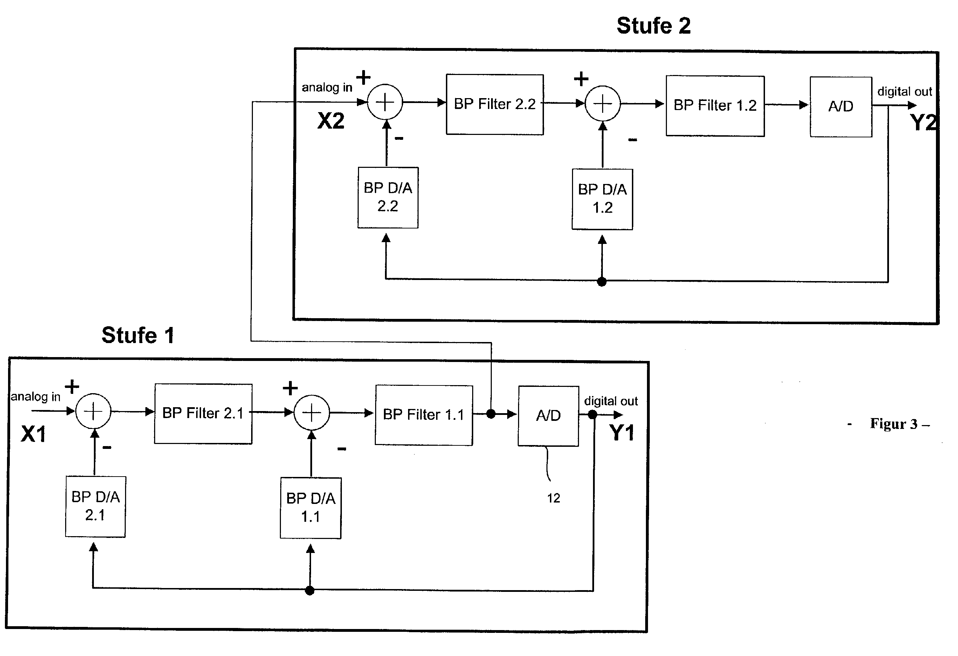

Figur 3 zeigt einen Bandpass-Sigma-Delta-Modulator zweiter Ordnung gemäß dem Stand der Technik, welcher als zweistufige Kaskade aufgebaut ist. Das Eingangssignal des Analog-Digital-Wandlers 12 der ersten Stufe der Kaskade bildet hierbei das Eingangssignal X2 der zweiten Stufe der Kaskade.

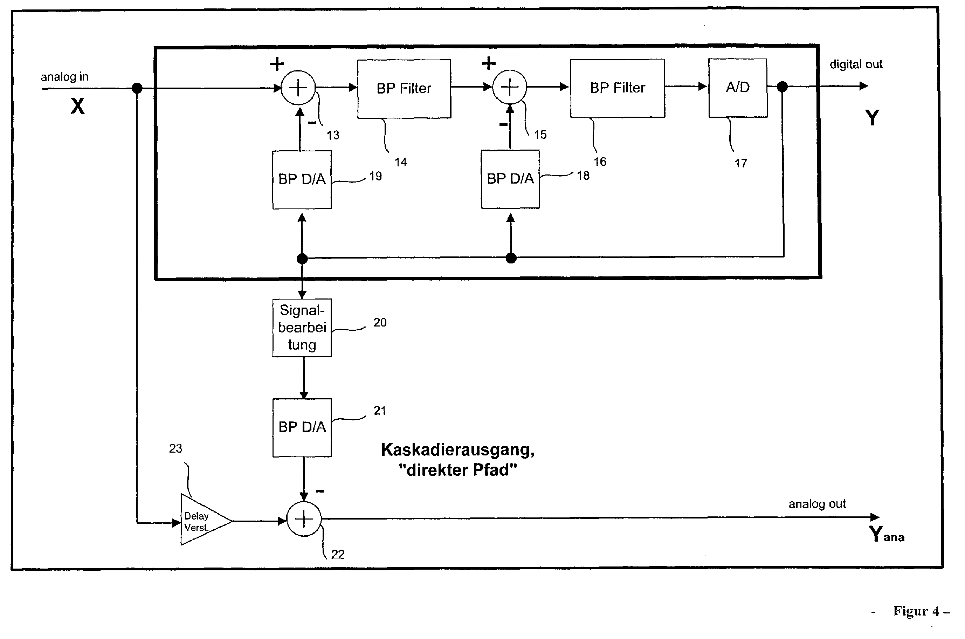

In Figur 4 ist ein erfindungsgemäßer einstufiger Bandpass-Sigma-Delta-Modulator dargestellt. Das analoge Eingangssignal X wird über einen Summierer 13 einem ersten Bandpass 14 zugeführt und das gefilterte Signal wird über einen weiteren Summierer 15 geführt und erneut in einem Bandpass 16 gefiltert. Anschließend wird das analoge Signal in einem Analog-Digital-Wandler 17 quantisiert. Das derart erzeugte digitale Signal bildet einerseits das digitale Ausgangssignal Y des Sigma-Delta-Modulators und wird andererseits über jeweils einen Bandpass-Digital-Analog-Wandler 18 bzw. 19 analogisiert und mit negativem Vorzeichen den Summierern 13 bzw. 15 zugeführt.

Das digitale Ausgangssignal Y kann über einen sogenannten "direkten" Pfad einer Signalbearbeitung 20 zugeführt werden. Anschließend wird das Signal in einem weiteren Bandpass-Digital-Analog-Wandler 21 umgewandelt und mit negativem Vorzeichen einem Summierer 22 zugeführt. Als Beispiel für eine mögliche Signalbearbeitung des Signals kann eine Abtastratenerhöhung genannt werden, welche dazu führt, dass der Bandpass-Digital-Analog-Wandler 21 mit einer gegenüber den Bandpass-Digital-Analog-Wandlern 14 und 16 erhöhten Taktfrequenz arbeitet. Der Vorteil einer derartigen Bearbeitung liegt in der Erhöhung der Leistung einer Oberwelle des Bandpass-Digital-Analog-Wandler 11, welches den Leistungsverbrauch des Gesamtsystems im Oberwellenbetrieb reduziert.

Eine weitere Möglichkeit der Signalbearbeitung des digitalen Ausgangssignals Y im "direkten" Pfad ist der Einsatz einer digitalen Amplituden- oder Phasenkorrektur. Bei dieser digitalen Berechnung werden mehrere, gegeneinander zeitverzögerte Signale gewichtet miteinander addiert. Hierdurch erhöht sich die Anzahl der Quantisierungsstufen des digital nachbehandelte Signals gegenüber der Anzahl der Quantisierungsstufen des Ausgangssignals Y. Mit Hilfe eines zusätzlichen digital realisierten Sigma-Delta-Modulators kann dieses mehrstufige Signal wieder in der Stufenanzahl reduziert werden.

Wie aus Figur 4 ersichtlich, wird das analoge Eingangssignal X ebenfalls dem Summierer 22 zugeführt. Das resultierende Signal bildet das analoge Ausgangssignal $Y_{ana}$ des Sigma-Delta-Modulators, welches zusammen mit dem digitalen Ausgangssignal Y einer (hier nicht dargestellten) Auswerteeinheit zugeführt wird. Das analoge Signal X wird, bevor es zu dem Summierer 22 gelangt, vorteilhaft über einen Verstärker 23 geführt, der mit einem Verzögerer kombiniert sein kann. Auf diese Weise können die Eingangsamplituden und die Phasenlage der zu dem Summierer 22 geführten Signale angeglichen werden. Am Eingang des Bandpass-Digital-Analog-Wandlers 21 kann ferner eine Möglichkeit zur Phasenkorrektur des Signals vorgesehen sein.

Da der Bandpass-Digital-Analog-Wandler 21 sich erfindungsgemäß nicht im rückgekoppelten Zweig des Sigma-Delta-Modulators befindet und somit keine Auswirkungen auf die Stabilität des Regelkreises hat, braucht keine Rücksicht auf die durch ihn verursachten Verzögerungszeiten genommen zu werden.

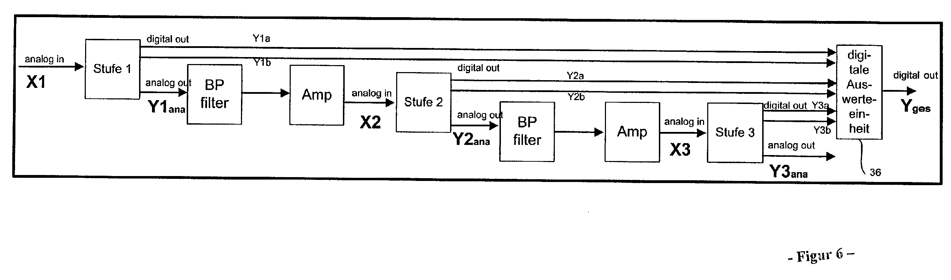

Das Signal-Rauschverhältnis des erfindungsgemäßen Sigma-Delta-Modulators wird allein durch das Signal-Rausch-Verhältnis des "direkten" Pfades, bestehend aus Signalbearbeitung 20 und Bandpass-Digital-Analog-Wandler 21, bestimmt. Der Grund hierfür ist folgender: Durch Nichtidealitäten des Analog-Digital-Wandlers 17 hervorgerufene Verzerrungen treten sowohl im "direkten" Pfad wie auch im digitalen Ausgangssignal Y auf. Das Signal des direkten Pfades wird durch den Analog-Digital-Wandler des in der Kaskade nachfolgenden Sigma-Delta-Wandlers gemessen und einer nachfolgenden digitalen Auswerteeinheit (siehe Figur 6) zur Verfügung gestellt. In dieser kann durch einfache Vorentzerrung und Linearkombination der Signale die Verzerrung rechnerisch bestimmt und entfernt werden. Daher können im rückgekoppelten Teil des Sigma-Delta-Modulators in einem erhöhten Maße Nichtlinearitäten der Bauteile, insbesondere der Filter, toleriert werden. Im folgenden wird dieser Sachverhalt näher erläutert:

Es soll ein möglichst exakte Analog/Digital-Wandlung des analogen Signals X vorgenommen werden. Es wird angenommen, dass bei den Mischern bzw. den A/D-Wandlern Störungen auftreten, die sich auf das digitale Ausgangssignal auswirken. Alle einzelnen Störungen seien in einem gemeinsamen Fehlersignal $E_{AD}$ zusammengefaßt, so dass für das digitale Ausgangssignal Y gilt:

$$Y = X + E_{AD}$$

Durch die Bandpaß-D/A-Wandlung im direkten Pfad treten in erster Näherung nur lineare Verzerrungen des digitalen Ausgangssignals auf, die in dem betrachteten Band sehr gut mit einer einfachen Signalskalierung verglichen werden können. Die verbleibenden nichtlinearen Verzerrungen werden für diese Betrachtung in dem Fehlersignal $E_{BPAD}$ zusammengefaßt.

$$Y_{ana} = H_{BPDA}\, Y + E_{BPDA}$$

Dieses Signal wird erfindungsgemäß von dem analogen Signal X subtrahiert und als analoges Kaskadiersignal über ein Filter (Übertragungsfunktion $H_{ana}$) sowie einen Verstärker (Verstärkung V)dem A/D-Wandler der nächsten Kaskade zugeführt.

$$X_2 = H_{ana} V (X - Y_{ana})$$

Auch dieser zweite A/D-Wandler ist nicht optimal:

$$Y_2 = X_2 + EAD_2$$

Im einfachsten Fall einer zweistufigen Kaskade liegen also der digitalen Auswerteeinheit die Signale Y und $Y_2$ vor.

$$
\begin{aligned}
Y_2 \;&=\; H_{ana} V (X - Y_{ana}) + E_{AD_2} \\
&=\; H_{ana} V (X - H_{BPDA} Y - E_{BPDA}) + E_{AD_2} \\
&=\; H_{ana} V (X - H_{BPDA} Y - E_{BPDA}) + E_{AD_2} \\
&=\; H_{ana} V (X - H_{BPDA}(X + E_{AD}) - E_{BPDA}) + E_{AD_2} \\
&=\; H_{ana} V ((1 - H_{BPDA}) X + H_{BPDA} E_{AD} - E_{BPDA}) + E_{AD_2}
\end{aligned}
$$

Es wird durch schaltungstechnische Maßnahmen angestrebt, dass in dem betrachteten Frequenzband

$$H_{BPDA} \approx 1$$

gilt. Damit erhält man

$$Y_2 \approx H_{ana} V (E_{AD} - E_{BPDA}) + E_{AD2}$$

Wegen des gleichartigen Aufbaus der kaskadierten A/D-Wandler ist die Leistung des durch diese Wandler eingebrachten Fehlers als in der gleichen Größenordnung anzunehmen, während die Leistung des Fehlersignals der Bandpass-D/A-Wandler sehr viel geringer ist. Da für den Verstärkungsfaktors $H_{ana}V \gg 1$ gilt, vereinfacht sich die Darstellung für $Y_2$ weiter:

$$Y_2 \approx H_{ana} V E_{AD}$$

Bis auf einen unbekannten Frequenzgang des analogen Filters - das nur bei einer geringen Anzahl von Quantisierungsstufen zwingend notwendig ist - mißt man mit dem Kaskadierausgang den durch den ersten A/D-Wandler eingebrachten Fehler.

Dieser Idealfall gilt nur dann, wenn der Fehlereinfluß des direkten Pfades vernachlässigt werden kann. Ist dies nicht der Fall, so erhält man

$$Y_2 \approx H_{ana} V (E_{AD} - E_{BPDA})$$

Man kann in $Y_2$ nicht zwischen Fehler des A/D-Wandlers und des Bandpass-D/A-Wandlers unterscheiden und den Fehler in Y deshalb auch nur mit der Güte des BP-D/A-Wandlers (des direkten Pfades) realisieren.

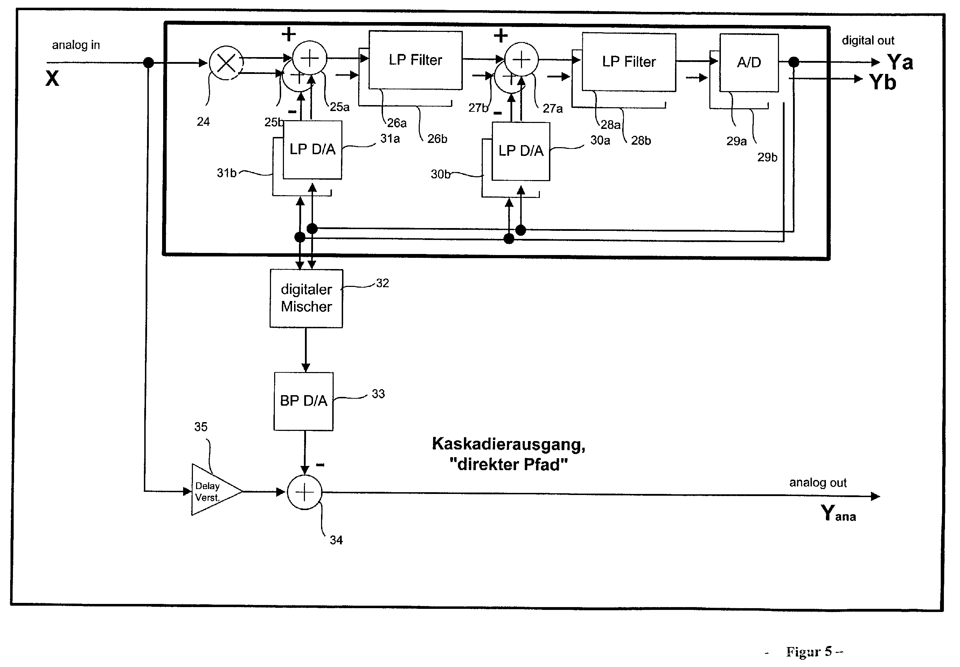

Gemäß einer weiteren Ausführungsform der Erfindung können in dem rückgekoppelten Teil des Sigma-Delta-Modulators anstelle der Bandpässe Tiefpässe verwendet werden. Diese Ausführungsform ist in Figur 5 dargestellt. Hierzu wird das analoge Eingangssignal X mit Hilfe eines Mischers 24, in dem eine Multiplikation des Signals mit jeweils einem cos- und einem sin-Signal erfolgt, in eine Inphase- und eine Quadratur-Komponente aufgespalten und in das komplexe Basisband umgesetzt (Direct Conversion). Beide Signalkomponenten werden parallel verarbeitet und jeweils durch Tiefpässe 26a bzw. 26b und 28a bzw. 28b gefiltert und anschließend in einem Analog-Digital-Wandler 29a bzw. 29b quantisiert. Auch die Rückführung der digitalen Signale Ya bzw. Yb erfolgt in zwei parallelen Rückkopplungszweigen mit Tiefpass-Digital-Analog-Wandlern 30a bzw. 30b und 31a bzw. 31b. Durch die Umsetzung des HF-Eingangssignals X in das komplexe Basisband können frequenzunabhängige Digital-Analog-Wandler 30a bzw. 30b und 31a bzw. 31b eingesetzt werden. In den "direkten" Pfad wird zusätzlich ein digitaler Mischer 32 aufgenommen, welcher neben der Zusammenführung der Inphaseund der Quadraturkomponente des Signals auch eine weitere Signalbearbeitung wie bereits unter Figur 4 beschrieben, durchführen kann. Anschließend wird das Signal, wie beschrieben weiterverarbeitet.

Ermöglicht wird die erfindungsgemäße Ausführungsform mit direkter Umsetzung des Signals in das komplexe Basisband durch die herabgesetzten Anforderungen an die Linearität der Bauteile im rückgekoppelten Teil des Sigma-Delta-Modulators. Fehlersignale, welche durch das Rauschen des Mischers 32, die durch ihn eingebrachten Nichtlinearitäten sowie einen I/Q-Mismatch hervorgerufen werden, finden sich sowohl in dem digitalen als auch in dem analogen Ausgangssignal Y bzw. $Y_{ana}$ wieder, so daß der Fehler durch geeignete Verfahren bestimmt und behoben werden kann.

Figur 6 zeigt die Gesamtstruktur eines erfindungsgemäßen dreistufig kaskadierten Systems von Sigma-Delta-Modulatoren mit direkter Umsetzung in das komplexe Basisband. Hierzu werden drei Sigma-Delta-Modulatoren derart kaskadiert, daß das jeweilige analoge Ausgangssignal $Y1_{ana}$ ($Y2_{ana}$, $Y3_{ana}$) einer Stufe des Sigma-Delta-Modulators das analoge Eingangssignal X1 (X2, X3) der folgenden Stufe des Sigma-Delta-Modulators bildet. Von jeder Stufe des Systems werden jeweils die Inphase- und die Quadraturkomponente als zwei digitale Ausgangssignale Y1a, Y1b (Y2a, Y2b, Y3a, Y3b) einer digitalen Auswerteeinheit 36 zugeführt, welche aus der Gesamtheit der digitalen Eingangssignale (Y1a, Y1b, Y2a, Y2b, Y3a, Y3b) das digitale Ausgangssignal $Y_{ges}$ bestimmt. Die mehrfache Kaskadierung des Sigma-Delta-Modulators ermöglicht eine genaue Bestimmung der Ausgangssignale des direkten Pfades jeder Stufe und somit der Nichtlinearitäten der Analog-Digital-Wandler aller Stufen der Kaskade mit Ausnahme der letzten. Da nur an der ersten Stufe das Eingangssignal gemessen wird, ist der hier auftretende Fehler von besonderer Bedeutung.

**Patentansprüche**

1. Sigma-Delta-Modulator zur Digitalisierung eines Hochfrequenz-Eingangssignals mit einem analogen Eingang, einem digitalen Ausgang und einem Rückkoppelzweig zur Unterdrückung von Quantisierungsfehlern, **dadurch gekennzeichnet, daß** er Mittel zur Umwandlung des digitalen Ausgangssignals in ein analoges Signal und Mittel zur Subtraktion des umgewandelten Signals von dem analogen Eingangssignal aufweist, wobei das derart erzielte analoge Summensignal an einem analogen Ausgang anliegt.

2. Sigma-Delta-Modulator nach Anspruch 1, **dadurch gekennzeichnet, daß** er Mittel aufweist, durch die Amplitude, Frequenz und/oder Phasenlage des analogen Eingangssignals veränderbar sind.

3. Sigma-Delta-Modulator nach einem der vorhergehenden Ansprüche, **dadurch gekennzeichnet, daß** er Mittel zur Signalbearbeitung aufweist.

4. Sigma-Delta-Modulator nach einem der vorhergehenden Ansprüche, **dadurch gekennzeichnet, daß** er zur Frequenzumsetzung des Hochfrequenz-Eingangssignals Bandpässe aufweist.

5. Sigma-Delta-Modulator nach einem der vorhergehenden Ansprüche, **dadurch gekennzeichnet, daß** er zur Umsetzung des Hochfrequenz-Eingangssignals analoge Mischer aufweist.

6. Sigma-Delta-Modulator nach einem der vorhergehenden Ansprüche, **dadurch gekennzeichnet, daß** er analoge Mischer zur Aufspaltung des Eingangssignals in eine Inphase- und eine Quadraturkomponente sowie Tiefpässe zur Umsetzung der Inphase- und der Quadraturkomponente des Hochfrequenz-Eingangssignals in niederfrequentere Signale aufweist.

7. System zur Umwandlung eines analogen Eingangssignals in ein digitales Ausgangssignal mit n Sigma-Delta-Modulatoren (n = 1, 2, 3, ...) nach einem der vorhergehenden Ansprüche, **dadurch gekennzeichnet, daß** die Sigma-Delta-Modulatoren derart kaskadiert sind, daß das jeweilige analoge Ausgangssignal eines Sigma-Delta-Modulators das Eingangssignal eines folgenden Sigma-Delta-Modulators bildet.

8. System nach Anspruch 7, **dadurch gekennzeichnet, daß** das System eine Einheit zur Auswertung der n digitalen Ausgangssignale der n Sigma-Delta-Modulatoren aufweist.

9. Verfahren zur Digitalisierung von analogen Hochfrequenzsignalen mit Hilfe von n Sigma-Delta-Modulatoren, mit folgenden Schritten, welche n-fach (n = 1, 2, ...) von a) bis e) wiederholt werden:

a) Filterung des analogen Eingangssignals,
b) Quantisierung des analogen Eingangssignals mit einer Abtastrate $f_a$, zu Zeitpunkten $t = m * T_a$, wobei m = 0, 1, 2,... und $T_a$ die Abtastperiode eines Sigma-Delta-Modulators ist, und Ausgabe des quantisierten Signals,
c) Umwandlung des quantisierten Signals in ein analoges Signal,
d) Subtraktion des umgewandelten analogen Signals von dem analogen Eingangssignal des Sigma-Delta-Modulators derselben Verfahrensstufe,
e) Verwendung des summierten Signals als analoges Eingangssignal des Sigma-Delta-Modulators der folgenden Verfahrensstufe,

und

- Auswertung der n quantisierten Signale der n Verfahrensstufen.

10. Verfahren zur Digitalisierung von analogen Hochfrequenzsignalen nach Anspruch 9, **dadurch gekennzeichnet, dass** das quantisierte Signal einer Verfahrensstufe eine Signalbearbeitung erfährt.

11. Verfahren zur Digitalisierung von analogen Hochfrequenzsignalen nach Anspruch 10, **dadurch gekennzeichnet, dass** das quantisierte Signal mit einer gegenüber der Abtastrate $f_a$ erhöhten Abtastrate $f_{erh}$ abgetastet wird.

12. Verfahren zur Digitalisierung von analogen Hochfrequenzsignalen nach Anspruch 10, **dadurch gekennzeichnet, dass** das quantisierte Signal eine Amplitudenund/oder Phasenkorrektur erfährt

– Figur 1 –

Figur 2 –

Figur 3

EP 1 227 594 A1

analog in

**X**

+

−

13

BP Filter

14

+

−

15

BP Filter

16

A/D

17

digital out

**Y**

BP D/A    19

BP D/A    18

Signal-
bearbei
tung

20

BP D/A    21

**Kaskadierausgang,
"direkter Pfad"**

23

Delay
Verst.

−

+

22

analog out

**Y**ana

– Figur 4 –

- Figur 5 -

EP 1 227 594 A1

– Figur 6 –

**Europäisches Patentamt**

# EUROPÄISCHER RECHERCHENBERICHT

**Nummer der Anmeldung**

EP 01 10 1969

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | WO 00 08765 A (STEENSGAARD MADSEN JESPER) 17. Februar 2000 (2000-02-17) * Abbildung 24 * | 1,7 | H03M3/02 |

**RECHERCHIERTE SACHGEBIETE (Int.Cl.7)**

H03M

Der vorliegende Recherchenbericht wurde für alle Patentansprüche erstellt

| Recherchenort | Abschlußdatum der Recherche | Prüfer |
|---|---|---|
| DEN HAAG | 10. September 2001 | Beindorff, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03 82 (P04C03)

**ANHANG ZUM EUROPÄISCHEN RECHERCHENBERICHT
ÜBER DIE EUROPÄISCHE PATENTANMELDUNG NR.**
EP 01 10 1969

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-09-2001

| Im Recherchenbericht angeführtes Patentdokument | Datum der Veröffentlichung | Mitglied(er) der Patentfamilie | Datum der Veröffentlichung |
|---|---|---|---|
| WO 0008765 A | 17-02-2000 | US 6271782 B<br>WO 0044098 A | 07-08-2001<br>27-07-2000 |

EPO FORM P0461

Für nähere Einzelheiten zu diesem Anhang : siehe Amtsblatt des Europäischen Patentamts, Nr. 12/82